Europäisches Patentamt

**European Patent Office**

**Office européen des brevets**

(19)

(11) Publication number: **0 061 852**

**A2**

(12) **EUROPEAN PATENT APPLICATION**

(21) Application number: **82301242.2**

(22) Date of filing: **11.03.82**

(51) Int. Cl.³: **H 01 R 43/02**
**H 01 R 4/02, G 05 F 1/02**

(30) Priority: **30.03.81 US 248775**

(43) Date of publication of application:
**06.10.82 Bulletin 82/40**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Landes, James L.**
**1703 Mimosa**
**Plano Texas 75074(US)**

(74) Representative: **Abbott, David John et al,**
**Abel & Imray Northumberland House 303-306 High**
**Holborn**
**London, WC1V 7LH(GB)**

(54) **Self starting current controlled discharge bonding wire ball maker.**

(57) An electronic flame off apparatus is disclosed having a high voltage supply 116 for initiating an arc, and a current supply 117 for maintaining the arc. This combination forms consistent balls 112 on a bond wire 111.

Fig. 1

SELF STARTING CURRENT CONTROLLED DISCHARGE BONDING WIRE BALL MAKER
BACKGROUND OF THE INVENTION

The interconnection of integrated circuits to lead frames is accomplished in a variety of manners. One method is the use of a bonding wire machine wherein typically a one mil aluminum or gold wire is pressed and either heated or ultrasonically vibrated during the press to a bond pad sufficiently to cause a weld between the wire and the bond pad. The wire then is drawn to the lead frame bond pad and again pressed combined with ultrasonic energy or heat or combination to cause a weld at that end of the wire. One method of this interconnection utilizes a melted ball on the tip of the wire for the first connection. This technique is called ball bonding. The balls for this bonding technique are formed by applying heat to the tip of the bonding wire such that the wire melts. As it melts it forms a liquid molten ball on the tip of the wire typically two to three times the diameter of the wire itself. This has been accomplished by the use of a hydrogen flame and by the use of electric discharge to the tip of the wire. While the hydrogen flame is effective and produces consistent ball sizes and shapes, it has inherent drawbacks in that it is hazardous to use in a manufacturing environment when alternatives are available.

The electronic flame off technique or EFO, also has disadvantages in that the spark discharge is typically initiated by either a high voltage across an air gap between the tip of the wire and an electrode or by causing contact with the electrode with a relatively low voltage in the neighborhood of 30 to 40 volts. The contact method of spark initiation has two main drawbacks in that the electrode rapidly becomes contaminated and must be cleaned periodically. Another drawback of the contact method is that if the spark should fail before complete ball formation. There is insufficient voltage to reinitiate the spark and therefore an incomplete ball is formed. The high voltage spark initiation across the gap has the advantages of preventing excessive contamination on the electrode as well as maintaining a high enough voltage to cause reinitiation of the spark should it fail. Additionally, this EFO technique is commonly done in an inert gas environment primarily to prevent excessive oxide buildup on the surface of the molten metal while the ball is forming. This oxide causes an excessive surface tension and can produce deformed balls. One common method of causing a high voltage spark initiation is to apply a capacitor across the electrode and the tip of the bonding wire such that high voltage sufficient to cause spark initiation is present and as the arc proceeds, the voltage across the capacitor will decrease until the electrical energy is spent in the arc. By the use of various capacitive sizes, the desired energy can be inputted to the tip of the wire and thus cause relatively consistent ball sizes. For further information, see "Bonding Tools and Techniques for the Automated 80's", published by the Gaiser Tool Company, Fall, 1980 issue.

There is a persistent problem, however, in obtaining consistent ball sizes and shapes with this method.

Accordingly, it is an object of the present invention to provide an electronic flame off apparatus and method which will form consistent balls as to size and shape.

It is another object of the present invention to provide an electronic flame off apparatus and method which will form consistent balls as to size and shape as well as provide an increased level of control over the amount of energy delivered to the ball during formation.

## SUMMARY AND BRIEF DESCRIPTION OF THE INVENTION

Briefly in accordance with the present invention, a method and apparatus are disclosed wherein wire bonding balls are formed by initiating an arc between the electrode and the tip of a bonding wire by causing a voltage potential between the electrode and the wire while spaced apart; maintaining the arc while regulating the current between said electrode and said wire; and providing an inert gas environment in the space between the wire tip and the electrode for the duration of the arc.

The disclosed method is used in conjunction with a manual or an automatic bonding machine to attain consistent ball formation and consequent consistent ball bonding by increasing the control over the amount of energy delivered to the wire tip during ball formation. The inert gas environment causes ionic formation and bombardment of the wire tip or the electrode while the arc is maintained.

One embodiment of the present invention utilizes a DC current and a DC voltage to achieve the objective of consistent ball size and shape.

Another embodiment utilizes a DC voltage to initiate the arc and an AC current supply to provide alternating direction of the inert gas plasma and thus prevent early oxide formation on the surface of the ball and in an alternating manner prevent arc byproduct buildup on the electrode.

## BRIEF DESCRIPTION OF THE DRAWINGS

The novel features believed characteristic of the invention are set forth in the appended claims. The invention itself, however, as well as other features and advantages thereof, will be best understood by reference to the detailed description which follows, read in conjunction with the accompanying drawings, wherein:

Figure 1 is a block diagram of the invented circuit shown connected to the actual components as used in operation.

Figure 2 is a partial circuit diagram of the disclosed invention showing the power supply section, the timing section and the high voltage arc initiating unit.

Figure 3 is a circuit diagram showing the current controlling aspect of the preferred embodiment and the interconnection means to the circuit shown in Figure 2.

DETAILED DESCRIPTION OF THE DRAWINGS

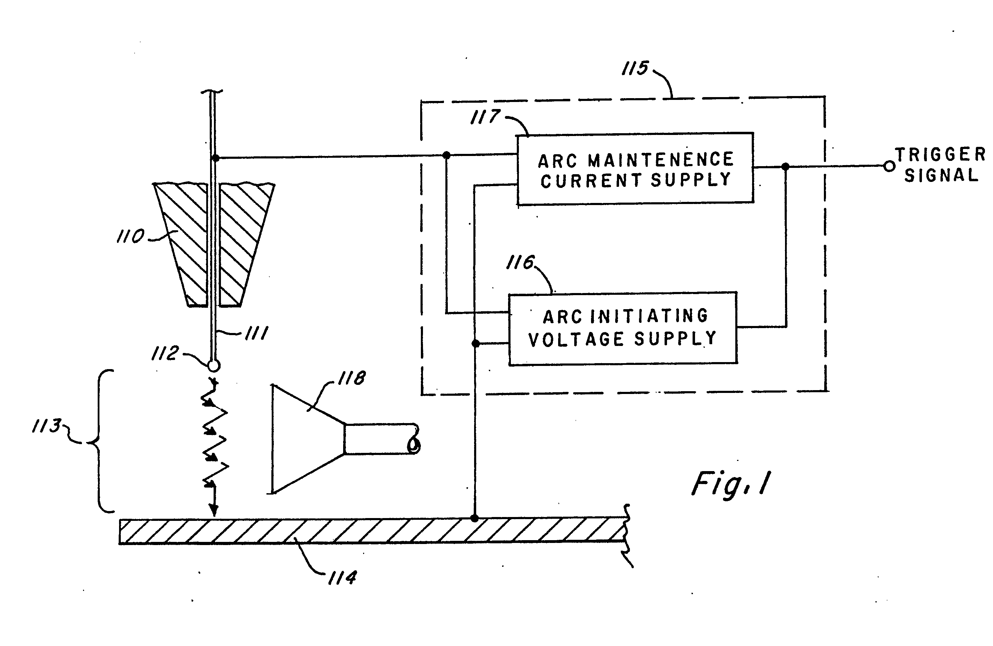

Referring now to Figure 1, a block diagram of the invented circuit as shown at 15, is shown connected to the actual components required for operation. A partial bonding tool, 110, is shown with a wire, 111, through the capillary. A ball is shown being formed at 112, as a result of the arc depicted at 113. Gold and aluminum wires have been successfully used in the present invention, with minor adjustments being required to increase or decrease the current magnitude and arc duration to achieve consistent ball formation in various wire sizes.

The electrode, 114, is a tungsten alloy typically used in E.F.O. applications. Orifice 118 is a depiction of an inert gas directing nozzle that is used to provide an inert environment for the arc.

The arc initiating voltage supply, 116 is triggered by either a manual switch or by computer control at the same time that the arc maintaining current supply, 117, is turned on.

During ball formation, the arc lengthens as the wire melts, gradually increasing the ball diameter as more wire is melted and adds to the size of the ball. Arc initiation is

-5-  0061852

obtained by applying a voltage between the electrode and the wire tip with a potential of between 500 to 1,000 volts, although 600 to 750 volts was found to be an optimum range for 1 mil aluminum wire.

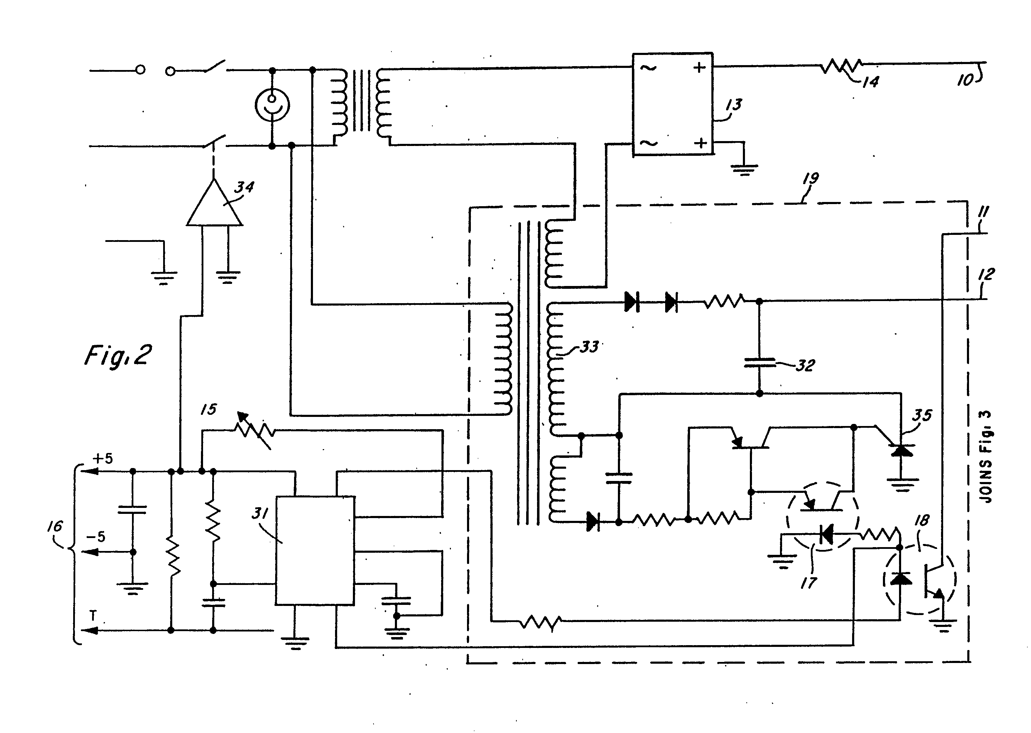

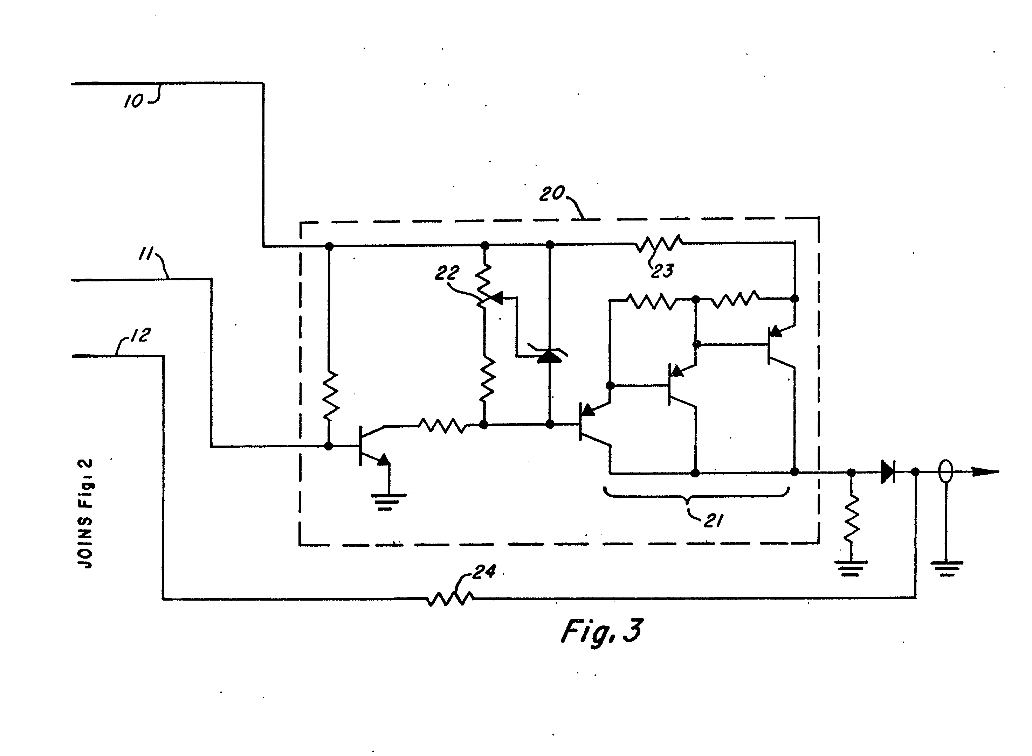

Referring now to Figure 2, the wires depicted at 10, 11 and 12 are connected to the circuitry shown in Figure 3. Rectifier 13 is placed in a position to provide a filtered DC current to the circuitry in Figure 3 and provide a DC current arc maintenance circuit. Resistor 14 is a 20 ohm resistor and is used primarily to guard agains excessive current in the circuit shown in Figure 3. Variable resistor 15 is the timing control for timer 31 and by appropriate adjustment of the resistor 15, the duration of the arc can be controlled. The three inputs at 16 are connected to a computer control which normally functions to move a bonding tool from point to point when bonding is in process. Refer to U.S.P. 4,098,447, Edson et al, for general background and which is incorporated herein by reference. These interconnections thus are controlled by a computer process or may be manually controlled such that a power supply voltage as well as a triggering signal are applied at these points. The circuitry shown at 17 is an opto coupler used to isolate the triggering circuitry from the high voltage arc initiation circuitry. The opto coupler shown at 18 is used to isolate the triggering circuitry from the current providing circuitry shown in Figure 3. The circuitry within the dotted line area shown at 19 is the high voltage arc initiation circuitry. Transformer 33 develops a voltage across capacitor 32 with the use of two diodes in series, a voltage across 32 of approximately 750 volts may be attained. The silicon controlled rectifier shown at 35 is normally in an off position and thus will be held by capacitor 32 at a negative 750 volts immediately prior to arc initiation. When a triggering signal is received at opto-coupler 17, this turns SCR 35 on thus driving the level of voltage across capacitor 32 on the negative side to ground, point 12 then will be driven to a +750 volts and provide the voltage differential in the circuit in Figure 3 sufficient to initiate an arc. A solid state relay at 34 is switched by the on-off switch to insure that the timing circuitry 31 is in an off position even when disconnected from a computer source at 16 or while other adjustments are being made, thus insuring that no accidental discharge occurs. A stray triggering signal thus is not likely to occur when the on-off switch is in the off position.

Referring now to Figure 3, connection points to the circuitry in Figure 2 are shown in Figure 3 at 10, 11 and 12. Darlington triplet circuitry shown at 21 is used to provide a current into the output at a controlled rate. The control of the current level is at resistor 22 and by controlling the triggering level of a zener diode shown connected to the resistor 22, the triggering level of the current source coming in at .11 may thus be controlled. Resistor 23 is selected to control the amount of current delivered at the output. A one ohm resistor at 23 will provide between 1 to 4 amperes of current depending on other circuit parameter selected and through proper utilization of appropriate circuit devices, the current outputted can be increased to as much as 40 amperes with the circuitry shown. The circuitry enclosed by the dotted line shown at 20 is the current providing circuitry which maintains and controls the amount of current and thus the amount of energy delivered during the arc. Resistor 24 is selected and is in series with the high voltage arc initiation circuitry to control the current magnitude of the high voltage circuitry inputted to the electrode during arc.

In normal operation the timer is adjusted at resistor 15 in Figure 2 for the appropriate configuration of the on signal to the current supply. The capacitor in Figure 2, number 32 and the resistor in Figure 3, number 24 are selected to provide a moderately slow decay rate for the voltage across capacitor 32. The current magnitude provided by the current source has been selected by resistor 23 having an appropriate value, and the triggering level has been calibrated for the current supply by adjustment of variable resistor 22.

When the trigger signal is inputted to the timing circuitry, the two opto couplers at 17 and 18 are triggered such that the high voltage is applied across the spark gap at the same time the signal to turn on the current supply is on. The high voltage circuitry provides a current of approximately one amp by the selection of resistor 24 at approximately 680 ohms which corresponds to a 1.1 amp current if a voltage of 750 volts is applied at capacitor 32. The arc having been initiated, a plasma path is developed which will support a current as may be required for consistent ball formation and as the capacitor decays should the arc break or fail for some reason since the voltage leakage through resistor 24 is moderately slow, there should be sufficient voltage to reinitiate the arc without an additional triggering signal. The arc maintenance circuitry having been triggered simultaneously with the initiation circuitry, produces a current at the arc of between 1 and 4 amperes. Once the arc is established, the plasma path reduces the voltage across the arc to approximately 30 to 40 volts. The duration of the arc is controlled by the timer circuitry. Thus the heat developed by the arc is controlled by the current density, and the total energy is controlled by the current timing duration. The DC current provided by the current supply section at 20 is calibrated 0061852 de sufficient energy to the wire tip to form an appropriate ball size and shape prior to being cut off by timer shown at 31. Additionally, an inert gas envelope is provided at the arc location which prevents excessive oxide buildup on the surface of the ball allowing the normal surface tension of the molten metal to form a more spherical shape than otherwise. The ionized inert gas, argon, for example, will impact upon the surface of the ball while it is forming and prevent oxide formation from occurring so rapidly that the molten metal does not have a good opportunity to form a spherical shape.

An alternative embodiment uses an alternating current supply section which is placed at circuitry shown at 20 and provides additional benefit of reversing the inert gas ionic flow in the plasma path of the arc such that the inert gas ions impact the eletrode and thus provides a cleaning cycle for the electrode every time that an arc is initiated. The appropriate frequency and current levels may be determined experimentally for various wire sizes and wire materials, however, one cycle per arc is useful as well as a thousand or more current alternating cycles during the arc.

While this invention has been described with reference to an illustrative embodiment, it is not intended that this description be construed in a limiting sense. Various modifications of the illustrative embodiment, as well as other embodiments of the invention, will be apparent to persons skilled in the art upon reference to this description. It is therefore contemplated that the appended claims will cover any such modifications or embodiments as fall within the true scope of the invention.

WHAT IS CLAIMED IS:

1.    A method for forming a wire bonding ball comprised of the steps of:

(a)    initiating an arc between an electrode and the tip of a bonding wire by causing a voltage potential between said electrode and said tip while spaced therefrom;

(b)    maintaining said arc by regulating the current between said electrode and said wire to control the energy delivered to said wire tip independently of said arc initiating voltage; and

(c)    providing an inert gas environment in the space between said wire tip and said electrode for the duration of said arc.

2.    A method for forming wire bonding balls as in Claim 1, further adding the step of switching from an independent voltage source after said arc is initiated to an independent current source for the remainder of the duration of said arc.

3.    A method for forming wire bonding balls as in Claim 1, wherein the step of maintaining said arc includes regulating the level of said current.

4.    A method for forming wire bonding balls as in Claim 1, wherein the step of maintaining said arc includes regulating the duration of said current.

5.    A method for forming wire bonding balls as in Claim 1, wherein the step of maintaining said arc includes regulating the frequency of said current.

6.    A method for forming wire bonding balls as in Claim 2, wherein said step of maintaining said arc includes regulating the level of said current.

7.    A method for forming wire bonding balls as in Claim 2, wherein said step of maintaining said arc includes regulating the duration of said current.

8.    A method for forming wire bonding balls as in Claim 2, wherein said step of maintaining said arc includes regulating the frequency of said current.

9.    An apparatus for forming wire bonding balls comprising:

     (a) means for  providing a voltage sufficient to initiate an arc between an electrode and the tip of a bonding wire while spaced apart;

     (b) current regulating means for controlling the amount of energy delivered to said wire tip independently of said arc initiating means; and

     (c) means for providing an inert gas environment around said arc.

10. An apparatus for forming wire bonding balls as in Claim 9, further including means for switching from said means for providing voltage after said arc is initiated to an independent current source for the remainder of the duration of said arc.

11. An apparatus for forming wire bonding balls as in Claim 9, wherein said current regulating means is comprised of means for regulating current level, arc duration and current frequency.

12. An apparatus for forming wire bonding balls as in Claim 10, wherein said means for regulating current is comprised of means for regulating current level, arc duration and current frequency.

13. An apparatus for bonding a wire to a bond pad comprising;

(a) means for initiating an arc between an electrode and the tip of a bonding wire utilizing a voltage supply;

(b) means for maintaining said arc utilizing a controlled current supply independent of said voltage supply, said arc resulting in ball formation on said tip;

(c) means for bonding said ball to a bonding pad; and

(d) means for interconnection, mounting, and timing control of said apparatus.

ARC MAINTENENCE CURRENT SUPPLY

ARC INITIATING VOLTAGE SUPPLY

TRIGGER SIGNAL

*Fig. 1*

Fig. 2

JOINS Fig. 3

0061852

Fig. 3

JOINS Fig. 2